# EUROPÄISCHE PATENTSCHRIFT

(11) **EP 2 205 391 B1**
(45) Veröffentlichungstag und Bekanntmachung des Hinweises auf die Patenterteilung: **13.04.2011**
(21) Anmeldenummer: 08846745.1
(22) Anmeldetag: 07.11.2008
(51) Int. Cl.: B23K 1/00, B23K 3/06, B23K 3/08, H05K 3/34

(54) **VERFAHREN ZUM BETRIEB EINER WELLENLÖTANLAGE UNTER VERWENDUNG VON PERFLOURIERTEM POLYETHER ZUM REAGIEREN MIT BLEIBEHALTIGEN VERUNREINIGUNGEN**
METHOD FOR OPERATION OF A WAVE SOLDERING SYSTEM WHICH USES PERFLUORIC POLYETHER FOR REACTION WITH IMPURITIES CONTAINING LEAD
PROCÉDÉ PERMETTANT DE FAIRE FONCTIONNER UN SYSTÈME DE BRASAGE À LA VAGUE, AVEC UTILISATION DE POLYÉTHER PERFLUORÉ POUR LA RÉACTION AVEC DES IMPURETÉS CONTENANT DU PLOMB

(30) Priorität: 09.11.2007 DE 102007053857
(43) Veröffentlichungstag der Anmeldung: 14.07.2010
(73) Patentinhaber: Endress+Hauser GmbH+Co. KG, 79689 Maulburg (DE)
(72) Erfinder: BIRGEL, Dietmar, 79650 Schopfheim (DE); GLATZ, Franz, 79106 Freiburg (DE)
(74) Vertreter: Andres, Angelika Maria
(86) Internationale Anmeldenummer: PCT/EP2008/065136
(87) Internationale Veröffentlichungsnummer: WO 2009/060068

(56) Entgegenhaltungen:
- WO-A-2008/006700
- US-A- 3 665 041
- US-A- 4 874 124
- US-A1- 2002 179 693

## Beschreibung

Die Erfindung betrifft ein Verfahren zum Betrieb einer Wellenlötanlage, die ein mit einem bleifreien Lot befülltes Lotbad aufweist, und im Betrieb eine Lotwelle generiert, mit der nacheinander über die Lotwelle geführte Baugruppen gelötet werdenl (siehe US 2002/179 693).

Löten ist ein thermisches Verfahren zum stoffschlüssigen Fügen von Werkstoffen, dass insb. in der Elektrotechnik und der Elektronik weit verbreitet ist. In industriellen Herstellungsprozessen werden z.B. elektronische Bauteile auf Leiterplatten aufgelötet. Bekannte Lötverfahren sind das Wellenlöten, und das Selektivlöten.

Beim Wellenlöten werden elektronische Baugruppen, wie z.B. Leiterplatten, mit elektronischen Bauteilen bestückt und über eine Lotwelle gefahren. Die Lotwelle wird dadurch erzeugt, dass in einem Lotbad bereitstehendes flüssiges Lot durch einen Spalt gepumpt wird.

Das Selektivlöten ist eine Variante des Wellenlötens, bei der nur definierte Teilbereiche der Baugruppe mit dem Lot in Berührung kommen. Dies geschieht beispielsweise in dem in einem Lotbad bereitstehendes flüssiges Lot durch kleine Düsen gepumpt wird, deren Abmessung an die Abmessungen der zu lötenden Flächen angepasst sind.

Beim Wellenlöten tritt das Problem auf, dass an der Oberfläche des Lotbades befindliches Lot oxidieren kann. Die hierdurch entstehenden Oxide, die so genannte Krätze, lagern sich auf der Lotoberfläche ab und können unter Umständen zu einer Verunreinigung oder sogar zu einer Verstopfung des die Lotwelle erzeugenden Spalts bzw. der Düse führen. Es ist daher üblich die Krätze in regelmäßigen Abständen von der Lotoberfläche zu entfernen. Dabei wird eine obere Schicht des Lotbades abgeschöpft und gegebenenfalls mit entferntes Lot ersetzt.

Es ist bekannt, die Bildung dieser Oxide durch eine auf die Lotoberfläche aufgebrachte Abdeckung aus einem Öl oder einem Gas, wie z.B. Stickstoff, zu reduzieren. Beide Verfahren können auch in Verbindung miteinander ausgeführt werden, in dem über der Ölabdeckung eine Gasabdeckung eingebracht wird.

In der CH 607 622 ist beispielsweise eine Wellenlötvorrichtung beschrieben, bei der sich auf dem flüssigen Lot eine Ölschutzschicht befindet, die dazu dient, ein Oxidieren des flüssigen Lotes zu verhindern.

Bei bleihaltigen Loten, wie z.B. den Zinn-Blei-Loten mit Schmelzpunkten von bis zu 180°C kann hierzu ein einfaches Öl verwendet werden. Bleifreie Lote weisen demgegenüber einen deutlich höheren Schmelzpunkt in der Größenordnung von 220°C und mehr auf. Bei diesen hohen Temperaturen sind einfache Öle nicht mehr einsetzbar.

In der am 10.07.2006 eingereichten Deutschen Patentanmeldung der Anmelderin mit dem Aktenzeichen: 10 2006 032 051.4 entsprechend WO 2008/006700, Artikel, 54(3) EPÜ) ist eine Wellenlötanlage beschrieben, bei der auf dem flüssigen Lot eine Abdeckung aus perfluoriertem Polyether mit einem Siedepunkt von über 260°C vorgesehen ist. Dieses Abdeckmedium ist auch in Verbindung mit bleifreien Loten zur Reduzierung der Oxidbildung einsetzbar.

Bei der Verwendung von Lötbädern besteht die Gefahr, dass sich Verunreinigungen in einem anfänglich reinen Lot anreichern. Dies geschieht beispielsweise, indem kleinere Mengen von in der Baugruppe enthaltenen Materialien während des Lötvorgangs von dem flüssigen Lot aufgenommen werden, und sich im Lötbad anreichern. Mögliche Quellen für Verunreinigungen sind dabei z.B. Bauteilmetallisierungen sowie beispielsweise mit Zinn/Blei vorbelotete Leiterplatten.

Verunreinigungen bewirken eine Veränderung der physikalischen und chemischen Eigenschaften des Lotes und führen in der Regel zu einer Verschlechterung der mit dem Lot erzielbaren Qualität der Lötverbindungen. Außerdem können sie, je nach Material der Verunreinigung eine Gefahr für Mensch und Umwelt darstellen.

Zum Schutz der Umwelt und von Personen ist man heute bemüht, Lote einzusetzen, die keine Schwermetalle, wie z.B. Blei oder Quecksilber enthalten.

In diese Richtung zielt auch die RoHS-Richtlinie (Restriction of Certain Hazardous Substances) der Europäischen Union, die den Einsatz bestimmter gefährlicher Stoffe, wie z.B. Blei, in der Elektroindustrie verbietet. Dabei werden Grenzwerte für die Konzentrationen der einzelnen potentiell gefährlichen Stoffe vorgegeben, die von den Herstellern einzuhalten sind. Hieraus ergeben sich entsprechende Grenzwerte für die Konzentration dieser Stoffe im Lot des Lotbads, die nicht überschritten werden dürfen.

Verunreinigungen des Lotbades mit potentiell gefährlichen Stoffen lassen sich jedoch nicht gänzlich ausschließen. Auch beim Einsatz bleifreier Lote kann es mit der Zeit zu einer Anreicherung von Blei im Lotbad kommen. Dies geschieht beispielsweise, indem kleinere Mengen von in der Baugruppe enthaltenem Blei während des Lötvorgangs von dem flüssigen Lot aufgenommen werden, und sich im Lötbad anreichern. Mögliche Bleiquellen sind dabei z.B. bleihaltige Bauteilmetallisierungen sowie mit Zinn/Blei vorbelotete Leiterplatten. Leiterplatten werden in der Regel für konkrete Anwendungen speziell angefertigt. Bleihaltige Metallisierungen der Leiterplatten können daher hier gezielt ausgeschlossen werden. Die darauf zu montierenden Bauteile sind dagegen in der Regel standardisiert und werden kurzfristig von unterschiedlichen zum Teil wechselnden Herstellern bezogen. Bleihaltige Metallisierungen von Bauteilen können daher nicht immer mit Sicherheit ausgeschlossen werden.

Um bleihaltigen Verunreinigungen im Lot und deren nachteilige Auswirkungen auf Mensch und Umwelt und/oder auf die Qualität der Lötverbindungen vorzubeugen, werden Lotbäder in regelmäßigen Abständen ausgetauscht. In der Regel wird hierzu die Bleikonzentration im Lotbad überwacht, und das Lotbad beim Überschreiten eines hierfür vorgegebenen Grenzwertes ausgewechselt. Jeder Austausch ist jedoch mit erheblichem Zeit- und Kostenaufwand verbunden. Es ist daher wünschenswert, die Anreicherung von bleihaltigen Verunreinigungen im Lotbad zu reduzieren, um die Zeitabstände zwischen zwei Badwechseln zu vergrößern.

Es ist eine Aufgabe der Erfindung ein Verfahren zum Betrieb einer mit einem bleifreien Lot befüllten Wellenlötanlage anzugeben, mit dem die Betriebsdauer der Anlage zwischen zwei aufgrund einer Anreicherung von bleihaltigen Verunreinigungen im Lotbad erforderlichen Badwechsein erheblich vergrößert werden kann.

Hierzu besteht die Erfindung in einem Verfahren zum Betrieb einer Wellenlötanlage gemäß Anspruch 1.

Gemäß einer Ausgestaltung des Verfahrens ist auf dem Lot im Lotbad eine Abdeckschicht aus perfluoriertem Polyether aufgebracht, in die das Lot der Lotwelle nach jedem Lötvorgang eintritt.

Gemäß einer ersten Weiterbildung wird der perfluorierte Polyether über eine Zuleitung gezielt in einen Bereich des Lotbads geführt, in dem die Lotwelle nach dem Lötvorgang in das Lotbad eintritt.

Gemäß einer Weiterbildung der ersten Weiterbildung ist eine Zufuhr des perfluorierten Polyethers an eine Taktrate gekoppelt, mit der nacheinander zu lötende Baugruppen über die Lotwelle gefahren werden, indem vor jedem Lotvorgang, bei dem eine Baugruppe über die Lotwelle fährt, einige Tropfen des perfluorierten Polyethers in den Bereich getropft werden, in dem das Lot der Lotwelle nach dem Lötvorgang wieder in das Lotbad eintritt.

Gemäß einer zweiten Weiterbildung wird die Lotwelle durch eine Lotführung erzeugt, durch die Lot aus dem Lotbad hindurch gepumpt wird, und der perfluorierte Polyether wird zwischen zwei Lötvorgängen in eine Mündung der Lotführung hinein getropft, und vor dem jeweils folgenden Lötvorgang mit dem Lot der Lotwelle in das Lotbad gespült.

Gemäß einer Weiterbildung der zweiten Weiterbildung wird die Lotwelle zwischen zwei Lötvorgängen abgeschaltet. Während die Lotwelle abgeschaltet ist wird mindestens ein Tropfen perfluorierter Polyether in die Lotführung eingebracht, und der eingebrachte perfluorierte Polyether wird beim Wiedereinschalten der Lotwelle von dem Lot aus der Lotführung herausgespült.

Ein Vorteil der Erfindung besteht darin, dass die Zeitintervalle zwischen zwei Badwechseln nun erheblich größer gewählt werden können, da ein großer Teil der in das Bad gelangenden bleihaltigen Verunreinigungen in dem perfluorierten Polyether gebunden wird, und durch einfaches Abschöpfen aus dem Lötbad entfernt wird.

Die Erfindung und weitere Vorteile werden nun anhand der Figuren der Zeichnung, in denen drei Ausführungsbeispiele dargestellt sind, näher erläutert; gleiche Teile sind in den Figuren mit gleichen Bezugszeichen versehen.

Fig. 1 zeigt eine Wellenlötanlage, bei der auf dem Lot im Lotbad eine Abdeckschicht aus perfluoriertem Polyether angeordnet ist;
Fig. 2 zeigt eine Wellenlötanlage, bei der perfluorierter Polyether über eine Zuleitung gezielt in einen Bereich des Lotbads eingebracht
   wird, in
   den das Lot der Lotwelle in das Lotbad eintritt; und
Fig. 3 zeigt eine Wellenlötanlage, bei der perfluorierter Polyether über eine Vorrichtung in die Lotführung eingetropft wird.

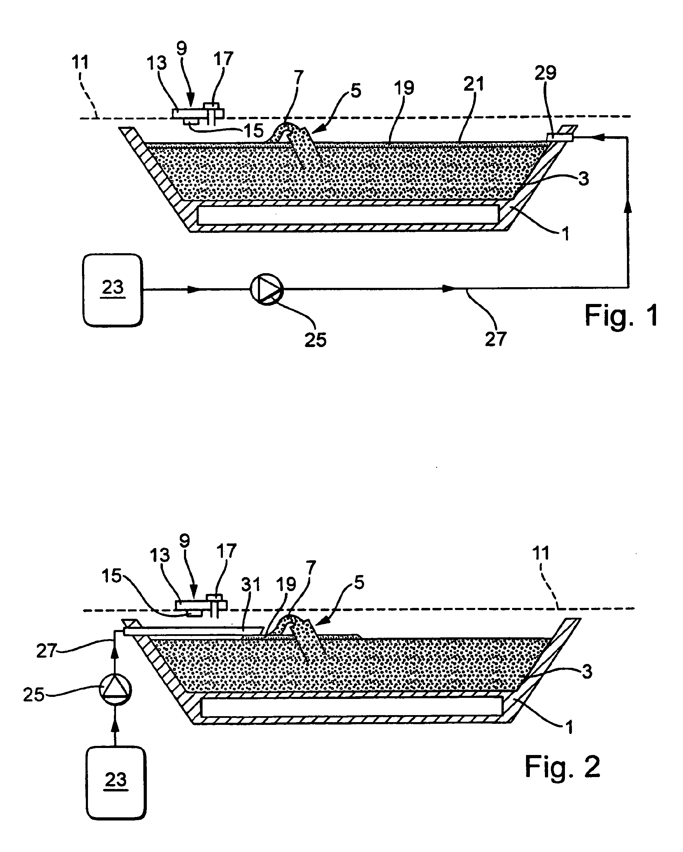

Die Erfindung betrifft ein Verfahren zum Betrieb einer Wellenlötanlage. In Fig. 1 ist schematisch ein erstes Ausführungsbeispiel einer Wellenlötanlage dargestellt. Sie weist ein Lotbad 1 auf, in dem sich im Lötbetrieb flüssiges bleifreies Lot 3 befindet. Das flüssige Lot 3 wird im Lötbetrieb durch eine aus dem Lotbad 1 herausragende Lotführung 5 herausgepumpt. Beim klassischen Wellenlöten ist die Lotführung 5 beispielsweise ein breiter Spalt, beim Selektivlöten beispielsweise eine Düse. Hierdurch entsteht über dem Flüssigkeitsspiegel des Lotes 3 im Lotbad 1 eine Lotwelle 7, über die die zu lötenden Baugruppen 9 mittels einer Baugruppenführung 11 geführt werden. Die exemplarisch dargestellte Baugruppe 9 umfasst eine Leiterplatte 13 und zwei elektronische Bauteile 15, 17. Das Bauteil 15 ist ein SMD-Bauteil, das auf der der Lotwelle 7 zugewandten Unterseite der Leiterplatte 13 angeordnet ist; das Bauteil 17 ist ein auf der gegenüberliegenden Oberseite der Leiterplatte 13 aufgebrachtes THT-Bauteil, dessen Anschlusspins durch die Leiterplatte 13 hindurch gesteckt sind. Die Baugruppenführung 11 ist in Fig. 1 lediglich in Form einer gestrichelten Linie angedeutet.

Die zu lötenden Baugruppen 9 können, wie eingangs beschrieben, bleihaltige Bestandteile aufweisen. Dabei besteht die Gefahr, dass sich Teile dieser bleihaltigen Bestandteile durch den Kontakt mit dem heißen Lot der Lötwelle 7 lösen und als Verunreinigung an das Lot der Lotwelle 7 abgegeben werden.

Um zu vermeiden, dass sich diese bleihaltigen Verunreinigungen im Lotbad 3 ansammeln, wird dem in das Lotbad 1 zurückgeführten Lot der Lotwelle 7 perfluorierter Polyether 19 zugeführt, der einen Siedepunkt aufweist, der oberhalb der Löttemperatur des bleifreien Lotes 3 liegt. Die Löttemperaturen von bleifreien Loten, wie z.B. Zinn-Silber-Loten, liegen üblicherweise zwischen 250°C und 260°C. Ein solcher perfluorierter Polyether 19 wird beispielsweise von der Firma Solvay Solexis unter dem Produktnamen Galden™ vertrieben. Ein weiterer in Verbindung mit der Erfindung einsetzbarer perfluorierter Polyether 19 ist ein von der Firma DAIKIN unter dem Produktnamen DEMNUM™ vertriebenes Perfluoropolytrimethylenoxid.

Unsere Untersuchungen haben gezeigt, das diese bei der Löttemperatur von bleifreien Loten flüssigen Öle in der Lage sind bleihaltige Verunreinigungen in bleifreien Loten zu binden. Hierzu wird der perfluorierte Polyether 19 erfindungsgemäß in den unmittelbaren Kontakt mit dem potentiell mit Blei verunreinigten Lot gebracht. Das potentiell verunreinigte Lot ist dabei das Lot der Lotwelle 7, das nach jedem Lötvorgang wieder in das Lotbad 1 zurück fließt. Die Zufuhr des perfluorierten Polyethers 19 in diese Region der Lotbadoberfläche kann auf vielfältige Weise erfolgen.

In Fig. 1 ist ein Ausführungsbeispiel dargestellt, bei dem die Zufuhr des perfluorierten Polyethers 19 erfolgt, indem auf dem Lot 3 im Lotbad 1 eine Abdeckschicht 21 aus perfluoriertem Polyether 19 aufgebracht wird.

Der perfluorierte Polyether 19 ist in einem Vorratstank 23 bereitgestellt, der über eine mit einer Pumpe 25 ausgestattete Anschlussleitung 27 mit einem oberhalb des Lotspiegels am Lotbadrand mündenden Einlauf 29 verbunden ist.

Die Abdeckschicht 21 überdeckt die gesamte Oberfläche des Lots 3 im Lotbad 1. Damit ist zwangsläufig auch derjenige Bereich des Lotbads 1 abgedeckt, in dem das potentiell mit bleihaltigen Verunreinigungen verunreinigte Lot der Lotwelle 7 wieder in das Lotbad 1 eintritt.

Der perfluorierte Polyether 19 bindet zumindest einen Teil der während des Lötvorgangs von der Baugruppe 9 an das Lot der Lotwelle 7 abgegebenen
bleihaltigen Verunreinigungen.
Die im perfluorierten Polyether 19 gebundenen bleihaltigen Verunreinigungen
werden aus dem Lotbad 1 entfernt, indem eine obere Schicht des Inhalts des Lotbads 1, in der sich der perfluorierte Polyether 19 mit den darin gebundenen bleihaltigen Verunreinigungen befindet, abgeschöpft wird. Dies ist auf einfache Weise möglich, da der perfluorierte Polyether 19 bei der Löttemperatur flüssig ist und auf dem Lot 3 schwimmt. Dabei wird die obere Schicht regelmäßig, z.B. täglich, oder bedarfsabhängig abgeschöpft. Entsprechend reduziert sich die Anreicherung von bleihaltigen Verunreinigungen im Lotbad 1 drastisch. Das Lotbad 1 kann wesentlich länger betrieben werden, bevor ein durch den Bleigehalt im Lotbad 1 bedingter Austausch erforderlich wird.

Die Abdeckschicht 21 wird nach jedem Abschöpfvorgang erneuert. Bei einem Lotbad 1 mit einer Füllmenge von 30 kg Lot 3 werden beim Abschöpfen in der Regel ca. 50 g bis 100 g des Lots 3 mit abgeschöpft. Diese dem Lotbad 1 entzogene Lotmenge wird ebenfalls nachgefüllt. Sie ist jedoch im Vergleich zur Gesamtmenge des Lots 3, die bei einem Badwechsel ersetzt werden muss verschwindend gering.

Die Menge des zuzuführenden perfluorierten Polyethers 19 kann ebenfalls sehr gering gehalten werden. Sofern die vollständig das Lotbad 1 überdeckende Abdeckschicht 21 nicht aus anderen Gründen, wie z.B. zur Reduzierung der Oxidbildung an der Lotoberfläche, benötigt wird, genügt es deutlich geringere Mengen perfluorierten Polyethers 19 einzusetzen, indem diese ganz gezielt dem Lot der Lotwelle 7 zugeführt wird, nachdem dieses mit der zu lötenden Baugruppe 9 in Kontakt gekommen ist.

Dies ist beispielsweise auf die in Fig. 2 dargestellte Weise realisierbar. Bei der dort dargestellten Wellenlötanlage wird der perfluorierte Polyether 19 über eine Zuleitung 31 unmittelbar in einen Bereich des Lotbads 1 geführt, in dem die Lotwelle 7 nach dem Lötvorgang wieder in das Lotbad 1 eintritt.

Der perfluorierte Polyether 19 wird auch hier in einem Vorratstank 23 bereitgestellt, und über eine mit einer Pumpe 25 ausgestattete Anschlussleitung 27 in die Zuleitung 31 gepumpt. Da die Zufuhr hier gezielt an den Ort erfolgt, an dem der perfluorierte Polyether 19 zur Bindung der bleihaltigen Verunreinigungen benötigt wird, genügen hier deutlich geringere Mengen des perfluorierten Polyethers 19. Vorzugsweise wird die Zufuhr an die Taktrate gekoppelt, mit der nacheinander zu lötende Baugruppen 9 über die Lotwelle 7 gefahren werden. In dem Fall genügt es beispielsweise, vor jedem Lötvorgang, bei dem eine Baugruppe 9 über die Lotwelle 7 fährt, einige Tropfen des perfluorierten Polyethers 19 in den Bereich zu tropfen, in dem das Lot der Lotwelle 7 nach dem Lötvorgang in das Lotbad eintritt.

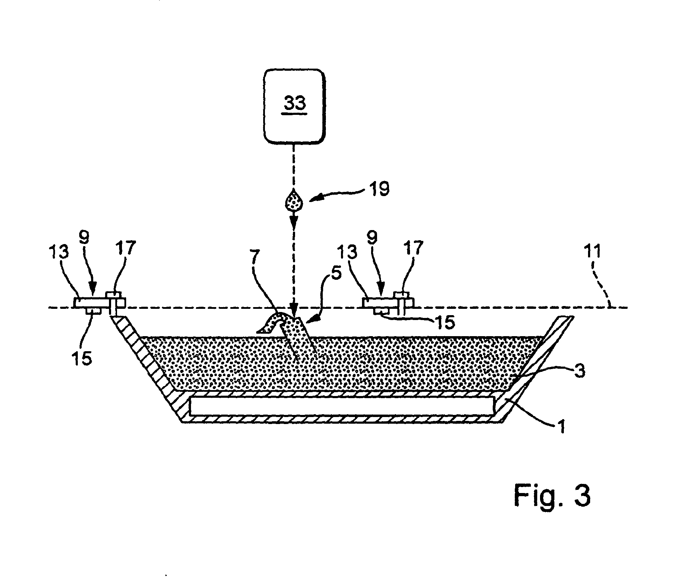

Fig. 3 zeigt ein weiteres Ausführungsbeispiel einer gezielten Zufuhr des perfluorierten Polyethers 19. Auch hier wird die Lotwelle 7 durch eine Lotführung 5 erzeugt, indem das Lot 3 aus dem Lotbad 1 durch die Lotführung 5 hindurch gepumpt wird. Über der Mündung der Lotführung 5, aus der das Lot der Lotwelle 7 austritt ist eine Vorrichtung 33 vorgesehen, die dazu dient geringe Mengen flüssigen perfluorierten Polyethers 19 in die Mündung der Lotführung 5 hinein zu tropfen. Die Vorrichtung 33 umfasst beispielsweise einen Vorratsbehälter und einen daran angeschlossenen Dispenser. Auch hier wird die Zufuhr an die Taktrate gekoppelt, mit der nacheinander zu lötende Baugruppen 9 über die Lotwelle 7 gefahren werden. Dabei wird zwischen zwei Lötvorgängen mindestens ein Tropfen perfluorierter Polyether 19 in die Mündung der Lotführung 5 hinein getropft. Der eingetropfte perfluorierte Polyether 19 wird unmittelbar von dem aus der Mündung ausströmenden Lot mitgerissen und vor dem jeweils folgenden Lötvorgang mit dem Lot der Lotwelle 7 in das Lotbad 1 gespült. Damit befindet es sich automatisch in dem Bereich auf der Lotoberfläche in den das beim nachfolgenden Lötvorgang mit der Baugruppe 9 in Kontakt gekommene potentiell mit Blei verunreinigte Lot der Lotwelle 7 in das Lotbad 1 eintritt.

Vorzugsweise wird dabei derart verfahren, dass die Lotwelle 7 zwischen zwei Lötvorgängen abgeschaltet wird. Während die Lotwelle 7 abgeschaltet ist wird mindestens ein Tropfen perfluorierter Polyether 19 in die Mündung der Lotführung 5 eingespritzt. Der eingespritzte perfluorierte Polyether 19 wird dann beim Wiedereinschalten der Lotwelle 7 von dem Lot aus der Lotführung 5 herausgespült.

Genau wie bei dem anhand von Fig. 1 beschriebenen Verfahren bindet der perfluorierte Polyether 19 bei den anhand von Fig. 2 und Fig. 3 beschriebenen Verfahren zumindest einen Teil der während der Lötvorgänge von den Baugruppen 9 an das Lot der Lotwelle 7 abgegebenen bleihaltigen Verunreinigungen. Im Unterschied zu dem anhand von Fig. 1 erläuterten Verfahren werden hierzu jedoch nur sehr geringe Mengen an perfluoriertem Polyether 19 benötigt. Entsprechend entstehen hierdurch deutlich geringere Verbrauchsmaterialkosten.

Die im perfluorierten Polyether 19 gebundenen bleihaltigen Verunreinigungen
werden auch hier aus dem Lotbad 1 entfernt, indem eine obere Schicht des Inhalts des Lötbads 1, in der sich der perfluorierte Polyether 19 mit den darin
gebundenen bleihaltigen Verunreinigungen befindet, abgeschöpft wird. Dabei wird die obere Schicht auch hier regelmäßig, z.B. täglich, oder bedarfsabhängig abgeschöpft. Entsprechend reduziert sich die Anreicherung von bleihaltigen Verunreinigungen im Lotbad 1 drastisch. Das Lotbad 1 kann wesentlich länger betrieben werden, bevor ein durch den Bleigehalt im Lotbad 1 bedingter Austausch erforderlich wird. Bei
Untersuchungen mit einer Testanlage, bei der die obere Schicht täglich abgeschöpft wurde, konnte die Betriebsdauer zwischen zwei Badwechseln verdreifacht werden.

**Tabelle 1**

| | |
|---|---|
| 1 | Lotbad |
| 3 | Lot |
| 5 | Lotführung |
| 7 | Lotwelle |
| 9 | zu lötende Baugruppe |
| 11 | Baugruppenführung |
| 13 | Leiterplatte |
| 15 | elektronisches SMD Bauteil |
| 17 | elektronisches THT Bauteil |
| 19 | perfluoriertes Polyether |
| 21 | Abdeckschicht |
| 23 | Vorratstank |
| 25 | Pumpe |
| 27 | Anschlussleitung |
| 29 | Einlauf |
| 31 | Zuleitung |
| 33 | Vorrichtung |

## Patentansprüche

1. Verfahren zum Betrieb einer Wellenlötanlage, die ein mit einem bleifreien Lot (3) befülltes Lotbad (1) aufweist, und im Betrieb eine Lotwelle (7) generiert, mit der nacheinander über die Lotwelle (7) geführte Baugruppen (9) gelötet werden, dadurch kenngezeichnet dass
- dem in das Lotbad (1) zurückfließenden Lot der Lotwelle (7) perfluorierter Polyether (19) zugeführt wird, der einen Siedepunkt aufweist, der oberhalb der Löttemperatur des bleifreien Lotes (3) liegt,
- der perfluorierte Polyether (19) zumindest einen Teil von während des Lötvorgangs von der Baugruppe (9) an das Lot der Lotwelle (7) abgegebenen bleihaltigen Verunreinigungen bindet, und
- die im perfluorierten Polyether (19) gebundenen bleihaltigen Verunreinigungen aus dem Lotbad (1) entfernt werden, indem eine obere Schicht des Lötbadinhaltes, in der sich der perfluorierte Polyether (19) mit den darin gebundenen bleihaltigen Verunreinigungen befindet, abgeschöpft wird.

2. Verfahren zum Betrieb einer Wellenlötanlage nach Anspruch 1, bei dem auf dem Lot (3) im Lotbad (1) eine Abdeckschicht (21) aus perfluoriertem Polyether (19) aufgebracht ist, in die das Lot der Lotwelle (7) nach jedem Lötvorgang eintritt.

3. Verfahren zum Betrieb einer Wellenlötanlage nach Anspruch 1, bei dem der perfluorierte Polyether (19) über eine Zuleitung (31) gezielt in einen Bereich des Lotbads (1) geführt wird, in den die Lotwelle (7) nach dem Lötvorgang in das Lotbad (1) eintritt.

4. Verfahren zum Betrieb einer Wellenlötanlage nach Anspruch 3, bei dem eine Zufuhr des perfluorierten Polyethers (19) an eine Taktrate gekoppelt ist, mit der nacheinander zu lötende Baugruppen (9) über die Lotwelle (7) gefahren werden, indem vor jedem Lötvorgang, bei dem eine Baugruppe (9) über die Lotwelle (7) fährt, einige Tropfen des perfluorierten Polyethers (19) in den Bereich getropft werden, in dem das Lot der Lotwelle (7) nach dem Lötvorgang wieder in das Lotbad (1) eintritt.

5. Verfahren zum Betrieb einer Wellenlötanlage nach Anspruch 1, bei dem die Lotwelle (7) durch eine Lotführung (5) erzeugt wird, durch die Lot (1) aus dem Lotbad (1) hindurch gepumpt wird, und der perfluorierte Polyether (19) zwischen zwei Lötvorgängen in eine Mündung der Lotführung (5) hinein getropft wird, und vor dem jeweils folgenden Lötvorgang mit dem Lot der Lotwelle (7) in das Lotbad (1) gespült wird.

6. Verfahren zum Betrieb einer Wellenlötanlage nach Anspruch 5, bei dem
- die Lotwelle (7) zwischen zwei Lötvorgängen abgeschaltet wird,
- während die Lotwelle (7) abgeschaltet ist mindestens ein Tropfen perfluorierter Polyether (19) in die Lotführung (5) eingebracht wird, und
- der eingebrachte perfluorierte Polyether (19) beim Wiedereinschalten der Lotwelle (7) von dem Lot aus der Lotführung (5) herausgespült wird.

## Claims

1. Method to operate a wave soldering machine which has a soldering tank (1) filled with lead-free solder (3) and which generates a solder wave (7) during operation which solders components (9) successively passed through the solder wave (7), **characterized in that**
- perfluorinated polyether (19) is added to the solder of the solder wave (7) flowing back into the soldering tank (1), said perfluorinated polyether having a boiling point above the soldering temperature of the lead-free solder (3)
- the perfluorinated polyether (19) bonds at least some leaded impurities released by the component (9) to the solder of the solder wave (7) during the solder process
- the leaded impurities bonded in the perfluorinated polyether (19) are removed from the soldering tank (1) by skimming off an upper layer of the contents of the soldering tank containing the perfluorinated polyether (19) with the bonded leaded impurities.

2. Method to operate a wave soldering machine as per Claim 1, where a coating (21) of perfluorinated polyether (19) is applied to the solder (3) in the soldering tank (1). The solder of the solder wave (7) passes through this coating after each soldering cycle.

3. Method to operate a wave soldering machine as per Claim 1, where the perfluorinated polyether (19) is specifically fed via a supply line (31) into a section of the soldering tank (1) in which the solder wave (7) enters the soldering tank (1) after the soldering cycle.

4. Method to operate a wave soldering machine as per Claim 3, where a supply of perfluorinated polyether (19) is coupled to a clock frequency at which components (9) to be soldered are run in succession through the solder wave (7) where, prior to every soldering cycle in which a component (9) passes through the solder wave (7), a few drops of the perfluorinated polyether (19) are released into the area in which the solder of the solder wave (7) re-enters the soldering tank (1) after the soldering cycle.

5. Method to operate a wave soldering machine as per Claim 1, where the solder wave (7) is generated by a solder guide (5) through which solder (1) is pumped from the soldering tank (1), and the perfluorinated polyether (19) is released into an opening of the solder guide (5) between two soldering cycles, and is washed into the soldering tank (1) with the solder of the solder wave (7) before the next soldering cycle.

6. Method to operate a wave soldering machine as per Claim 5 where
- the solder wave (7) is switched off between two soldering cycles
- at least one drop of perfluorinated polyether (19) is introduced into the solder guide (5) while the solder wave (7) is switched off and
- the introduced perfluorinated polyether (19) is rinsed out of the solder guide (5) by the solder when the solder wave (7) is switched back on.

## Revendications

1. Procédé destiné au fonctionnement d'une machine de soudage à la vague, qui comporte un bain de soudure (1) rempli de soudure sans plomb (3), et qui génère en fonctionnement une vague de soudure (7), laquelle permet de souder tour à tour, au moyen de la vague de soudure (7), les composants (9) guidés, **caractérisé en ce**
- **qu'**est ajouté à la soudure de la vague de soudure (7), dans le bain de soudure (1), du polyéther perfluoré (19), qui présente un point d'ébullition supérieur à la température de soudage de la soudure sans plomb (3),
- **que** le polyéther perfluoré (19) lie au moins une partie des impuretés plombifères cédées par le composant (9) à la soudure de la vague de soudure (7) lors du procédé de soudage,
et
- **que** les impuretés plombifères liées dans le polyéther perfluoré (19) sont éliminées du bain de soudure (1) en ce qu'est prélevée une couche supérieure du contenu du bain de soudure, dans laquelle se trouve le polyéther perfluoré (19) avec les impuretés plombifères, qui y sont liées.

2. Procédé destiné au fonctionnement d'une machine de soudage à la vague selon la revendication 1, pour lequel une couche de recouvrement (21) en polyéther perfluoré (19) est appliquée sur la soudure (3) dans le bain de soudure (1), dans laquelle la soudure de la vague de soudure (7) pénètre après chaque processus de soudage.

3. Procédé destiné au fonctionnement d'une machine de soudage à la vague selon la revendication 1, pour lequel le polyéther perfluoré (19) est acheminé de façon ciblée, par l'intermédiaire d'une conduite (31), dans une zone du bain de soudure (1), dans laquelle la vague de soudure (7) pénètre dans le bain de soudure (1) après le processus de soudage.

4. Procédé destiné au fonctionnement d'une machine de soudage à la vague selon la revendication 3, pour lequel une alimentation du polyéther perfluoré (19) est couplée à une fréquence d'impulsions, avec laquelle les composants (9) à souder successivement sont déplacés au-dessus de la vague de soudure (7), en ce qu'avant chaque processus de soudage, pour lequel un composant (9) est déplacé au-dessus de la vague de soudure (7), quelques gouttes de polyéther perfluoré (19) sont libérées dans la zone, dans laquelle la soudure de la vague de soudure (7) pénètre de nouveau dans le bain de soudure (1) après le processus de soudage.

5. Procédé destiné au fonctionnement d'une machine de soudage à la vague selon la revendication 1, pour lequel la vague de soudure (7) est générée par un dispositif de guidage de soudure (5), à travers lequel de la soudure (1) est pompée depuis le bain de soudure (1), et pour lequel des gouttes de polyéther perfluoré (19) sont libérées, entre deux processus de soudage, dans une ouverture du dispositif de guidage de soudure (5), et en amont duquel le processus de soudage suivant est à chaque fois rincé avec la soudure de la vague de soudure (7) dans le bain de soudure (1).

6. Procédé destiné au fonctionnement d'une machine de soudage à la vague selon la revendication 5, pour lequel
- la vague de soudure (7) est interrompue entre deux processus de soudage,
- pendant que la vague de soudure (7) est interrompue, au moins une goutte de polyéther perfluoré (19) est introduite dans le dispositif de guidage de soudure (5), et
- le polyéther perfluoré (19) introduit est rincé lors du réenclenchement de la vague de soudure (7) par la soudure issue du dispositif de guidage de soudure (5).
